# EUROPÄISCHE PATENTANMELDUNG

(11) **EP 4 411 795 A1**
(43) Veröffentlichungstag der Anmeldung: **07.08.2024**
(21) Anmeldenummer: 23154950.2
(22) Anmeldetag: 03.02.2023
(51) Int. Cl.: H01L 21/677, B65G 1/04

(54) **PRODUKTIONSSYSTEM**

(71) Anmelder: Siemens Aktiengesellschaft, 80333 München (DE)
(72) Erfinder: Übler, Wolfgang, 92237 Sulzbach-Rosenberg (DE)
(74) Vertreter: Siemens Patent Attorneys

(57) **Zusammenfassung**

Um bei einem Produktionssystem (1) mit Produktionsstationen (11,12,13), welche auf der Produktionsfläche (2) angeordnet sind, die Gehwege (2) freizuhalten, wird vorgeschlagen über der Produktionsfläche (2) ein Schienensystem (40) anzuordnen, wobei das Schienensystem (40) einen ersten Satz paralleler Schienen (41) und einen zweiten Satz paralleler Schienen (42) aufweist, welcher senkrecht zu dem ersten Satz paralleler Schienen (41) angeordnet ist, und durch diese Anordnung der Schienen (41,42) Öffnungen (0) vorhanden sind und die Öffnungen (0) deckungsgleich mit den Planrechtecken (A1,...,K21) angeordnet sind, wobei auf dem Schienensystem (40) Transportroboter (TR1) angeordnet sind, die Transportroboter (TR1) weisen eine Fahreinheit (FE) und eine Transporteinheit (TE) auf, die Fahreinheit (FE) ist ausgestaltet sich parallel zum Schienensystem (40) sowohl in einer x-Richtung als auch in einer y-Richtung zu bewegen, die Transporteinheit (TE) ist ausgestaltet mit einem Hebezeug (HZ) zum Transportieren von Materialbehältern (MB), wobei die Fahreinheit (FE) ein Planrechteck (A1,...,K21) abdeckt und das Hebezeug (HZ) der Transporteinheit (TE) ausgestaltet ist einen Materialbehälter (MB) durch eine Öffnung (0), auf einen Transportbehälterbereich (31,32,33) abzusenken bzw. von dem Transportbehälterbereich (31,32,33) zu heben.

## Beschreibung

Die Erfindung betrifft ein Produktionssystem umfassend eine Produktionsfläche, welche mit einem Raster in Planrechtecke aufgeteilt ist, eine Vielzahl von Produktionsstationen, welche auf der Produktionsfläche angeordnet sind, eine Vielzahl von Gehwegen, welche zwischen den Produktionsstationen angeordnet sind, eine Vielzahl von Arbeitsbereichen, wobei zumindest ein Arbeitsbereich einer Produktionsstation zugeordnet ist, wobei die jeweiligen Arbeitsbereiche mit den Gehwegen verbunden sind, eine Vielzahl von Transportbehälterbereichen, wobei zumindest eine Produktionsstation zugeordnet ist, wobei die jeweiligen Transportbehälterbereiche in einen Planrechteck angeordnet sind, ein Materialanforderungssystem, ausgestaltet das über die Produktionsstationen ausgesendete Materialanforderungen in Materiallieferaufträge umgesetzt werden und an ein Material-Verteil-System gesendet werden.

Bei heutigen bekannten Produktionssystemen, wie beispielsweise das Elektronikwerk in Amberg von der Siemens AG, findet eine Versorgung von Produktionsarbeitsplätzen bzw. Produktionsstationen mit Produktionsmaterialien manuell statt. Einrichter- und Bedien-Personal müssen sich die Materialien selbst an die entsprechende Linie bzw. Produktionsstation holen. Üblicherweise werden die Materialien in ESD-Behältern auf manuellen Transportwagen über Gehwege auf der Produktionsfläche von Pufferanlieferstichen eines Material-Verteil-Systems oder von Hebern der automatisierten Fördertechnik zum jeweiligen Arbeitsplatz geliefert. Eine Anlieferung von Material, beispielsweise an einen Pufferanlieferstich des Material-Verteil-Systems und der entsprechenden Heber geschieht, nach Anforderung durch das Personal in einem IT-System, voll automatisch über den Teil der Fördertechnik, eine Etage tiefer in dem sogenannten Untergeschoß befindet sich die Anlieferung und eine entsprechende Fördertechnik.

Auch letztendlich fertig verpackte Produkte werden an den Produktionsarbeitsplätzen wiederum in ESD-Behälter gefüllt, durch das Personal dem Logistiksystem bekanntgegeben und ebenfalls wieder auf manuellen Transportwagen über Gehwege auf der Produktionsfläche zu Ablieferstichen an das Material-Verteil-System oder den entsprechenden Hebern gebracht, von wo das Logistiksystem die Behälter automatisch in den Versandbereich transportiert.

Es ist Aufgabe der vorliegenden Erfindung ein Produktionssystem bereitzustellen, bei welchem das Personal der Produktionsstationen von nichtproduktiven Materialtransporten entlastet wird.

Die Aufgabe wird für das eingangs genannte Produktionssystem dadurch gelöst, dass über der Produktionsfläche ein Schienensystem angeordnet ist, wobei das Schienensystem einen ersten Satz paralleler Schienen und einen zweiten Satz paralleler Schienen aufweist, der zweite Satz Schienen ist senkrecht zu dem ersten Satz paralleler Schienen angeordnet, und durch diese Anordnung der Schienen, Öffnungen vorhanden sind und die Öffnungen deckungsgleich mit dem Planrechtecken angeordnet sind, wobei auf dem Schienensystem Transportroboter angeordnet sind, die Transportroboter weisen eine Fahreinheit und eine Transporteinheit auf, die Fahreinheit ist ausgestaltet, sich parallel zum Schienensystem sowohl in einer x-Richtung als auch in einer y-Richtung zu bewegen, die Transporteinheit ist ausgestaltet, mit einem Hebezeug zum Transportieren von Materialbehältern, wobei die Fahreinheit ein Planrechteck abdeckt und das Hebezeug der Transporteinheit ausgestaltet ist, einen Materialbehälter durch eine Öffnung, auf einen Transportbehälterbereich abzusenken bzw. von dem Transportbehälterbereich zu heben.

Mit großem Vorteil hat man nun eine Ver- und Entsorgung der Produktionsarbeitsplätze bzw. der Produktionsstationen durch eine Verlagerung in den Raum über Kopf der Produktionsfläche und der entsprechenden Produktionshardware und Infrastruktur geschaffen. Der Nachteil, dass der gesamte Transport zum einen durch produktives Personal geleistet werden muss und somit das Personal mit unproduktiven Material- und Behältertransporten beschäftigt war, ist nun behoben. Die Gehwege der Produktionsflächen für manuelle logistische Transporte zu verwenden ist nun hinfällig. Daher wurde mit der vorgeschlagenen Erfindung eine Lösung für den Bedarf der verschiedenen Transporte gefunden, aber dennoch bleibt die wertvolle Produktionsfläche davon unberührt.

Eine Auslastungsoptimierung kann durch eine Erhöhung der Anzahl der Transportroboter erfolgen.

Das Produktionssystem lässt sich hinsichtlich einer Auslastung weiter dadurch optimieren, wenn ein weiteres Schienensystem über dem bereits vorhandenen Schienensystem angeordnet ist. Das weitere Schienensystem wird dementsprechend deckungsgleich mit dem vorhandenen Schienensystem aufgebaut, so dass die Transportbehälter durch Öffnungen des weiteren Schienensystems und weiterhin durch Öffnungen des vorhandenen Schienensystems geführt werden können.

Eine weitere Ausgestaltung sieht vor, dass die Produktionsstationen eine Anforderungseinheit zum Absetzen von Materialanforderungen aufweisen. Auch kann die Anforderungseinheit leere Transportbehälter anfordern oder ein Abholen eines Transportbehälters anfordern.

Die Öffnungen des Schienensystems sind vorteilhafter Weise mit mindestens den Maßen 40cm x 60cm ausgestaltet, so dass Transportbehälter mit den Maßen durch die Öffnung gelangen können.

Bei diesem Aufbau des Produktionssystems mit einem gerasterten Schienensystem ist es von Vorteil, dass jede Position, also jedes Planrechteck des Rasters, als eine Quelle oder als ein Ziel für die Bewegung der Transportroboter genutzt werden kann. Das eingeführte Schienensystem kann leicht mit einem bereits bestehenden Logistiksystem an speziellen Stellen der bereits vorhandenen Stiche der Materialverteilsysteme und Heber angebunden werden.

Ein weiterer Vorteil ist, dass Ver- und Entsorgungspositionen an den Produktionsstationen, also die Transportbehälterbereiche, so nah wie gewünscht und erforderlich an die Produktionsstationen platziert werden können. Auch kann jederzeit ohne eine Hardwareänderung die Position der Transportbehälterbereiche versetzt werden, so dass das Produktionspersonal keine unnötigen Wege zurücklegen muss, um eine Maschine bzw. eine Produktionsstation mit Produktionsmaterial zu befüllen. Die Anlieferung von Materialien, beispielsweise an Pufferanlieferstiche oder an das Material-Verteil-System oder ein Heber geschieht in der Regel nach Anforderung durch das Personal in einem IT-System oder voll automatisch basierend auf einem Produktionsprogramm. Dazu ist es von Vorteil, wenn das Produktionssystem ein Materiallager aufweist, welches über eine Förderanlage mit dem Material-Verteil-System in Verbindung steht.

Folgender Aufbau eines Produktionssystems in einer Halle hat sich als vorteilhaft herausgestellt, ein Hallenboden bildet die Produktionsfläche, ein Untergeschoß beherbergt das Materiallager und die Förderanlage, ein Hallendach überdeckt die Produktionsfläche, wobei zwischen dem Hallendach und der Produktionsfläche das Schienensystem über den Produktionsstationen angeordnet ist.

Die Zeichnung zeigt ein Ausführungsbeispiel der Erfindung. Dabei zeigt die
- FIG 1: ein schematisch dargestelltes Produktionssystem in einer Schnittdarstellung,
- FIG 2: eine Unterteilung der Produktionsfläche durch ein Raster in Plan,
- FIG 3: das Raster mit den Planen und aufgezeigten Produktionsstationen,
- FIG 4a: das Prinzip einer ersten Art von Transportroboter,
- FIG 4b: das Prinzip einer zweiten Art von Transportroboter,
- FIG 5: das Prinzip der Übertragung von Materialanforderungen mit der anschließenden Ausgabe von Fahrbefehlen und
- FIG 6: das Produktionssystem mit einem zusätzlich eingebrachten Schienensystem.

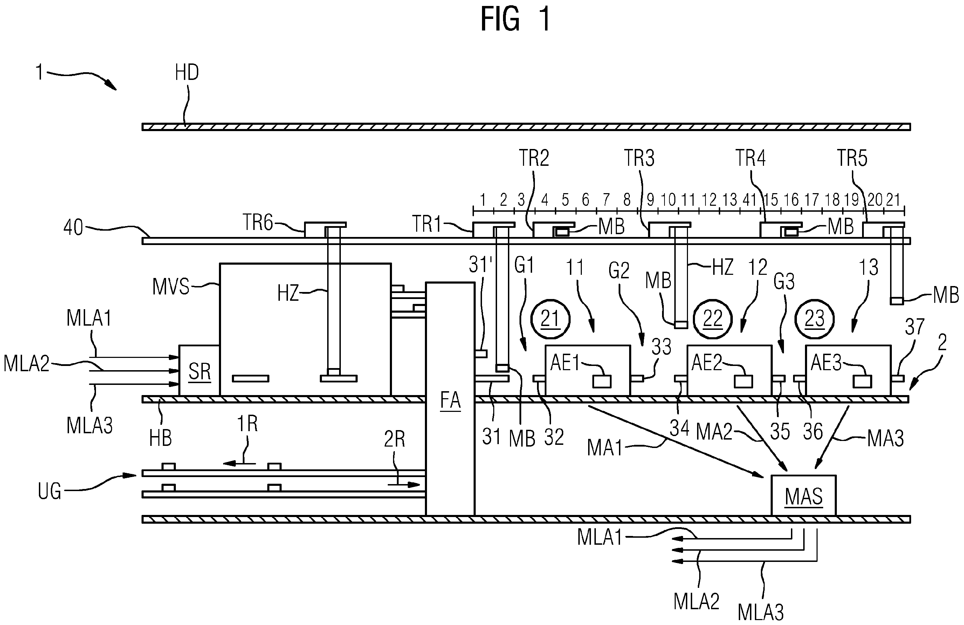

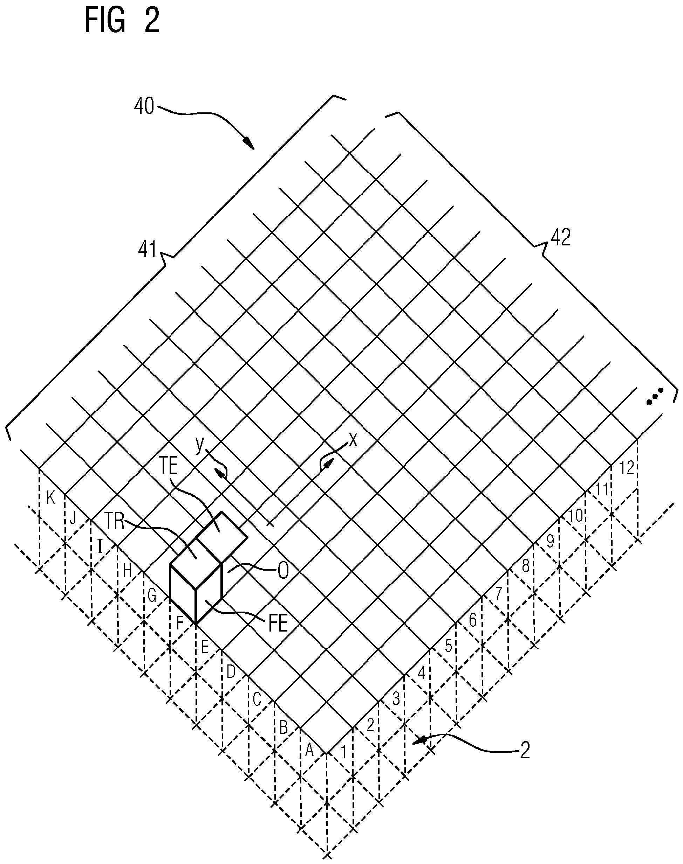

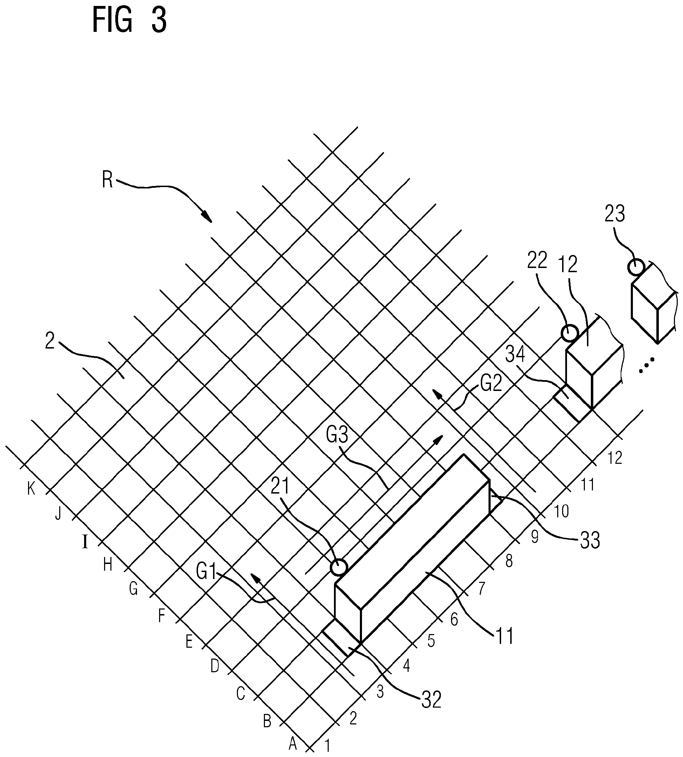

Gemäß FIG 1 ist ein Produktionssystem 1 als eine Schnittdarstellung in einer Produktionshalle dargestellt. Auf einem Hallenboden HB ist eine Produktionsfläche 2 angeordnet. Die Produktionsfläche 2 ist mit einem Raster R in Planrechtecke A1,...,K21 (siehe auch FIG 2) dargestellt. Durch die Darstellung des Produktionssystems 1 in einer Schnittdarstellung, ist gemäß FIG 1 nur die Rasterung von 1 bis 21 aufgezeichnet. Auf dem Hallenboden HB bzw. auf der Produktionsfläche 2 sind eine erste Produktionsstation 11, eine zweite Produktionsstation 12 und eine dritte Produktionsstation 13 angeordnet. Zwischen den Produktionsstationen 11,12,13 befinden sich Gehwege G1,G2,G3, wobei an den Produktionsstationen 11,12,13 Arbeitsbereiche 21,22,23 angeordnet sind. Die Arbeitsbereiche 21,22,23 sind über die Gehwege G1,G2,G3 verbunden. Für die erste Produktionsstation 11 ist ein erster Arbeitsbereich 21 an der Produktionsstation 11 angeordnet. Für die zweite Produktionsstation 12 ist an der zweiten Produktionsstation 12 ein zweiter Arbeitsbereich 22 angeordnet. Zur besseren Erkennbarkeit der Anordnung der Arbeitsbereiche 21,22,23 siehe FIG 3, in den Arbeitsbereichen 21,22,23 steht das Bedienpersonal und versorgt die Produktionsstation 11,12,13 mit Material aus Materialbehältern MB.

Das Produktionssystem 1 umfasst eine Vielzahl von Transportbehälterbereichen 31,...,37, wobei einer Förderanlage FA ein erster Transportbehälterbereich 31 zugeordnet ist. Der ersten Produktionsstation 11 ist linksseitig ein zweiter Transportbehälterbereich 32 und rechtsseitig ein dritter Transportbehälterbereich 33 zugeordnet. Der zweiten Produktionsstation 12 ist ebenfalls linksseitig ein vierter Transportbehälterbereich 34 und rechtsseitig ein fünfter Transportbehälterbereich 35 zugeordnet. Ebenso ist der dritten Produktionsstation 13 ein linksseitig angeordneter sechster Transportbehälterbereich 36 und ein rechtsseitig angeordneter siebter Transportbehälterbereich 37 zugeordnet. Im Zusammenspiel mit dem über der Produktionsfläche 2 angeordneten Schienensystem 40 sind die Transportbehälterbereiche 31,...,37 jeweils in einem Planrechteck A1,...,K21 des Rasters R angeordnet. So wird es ermöglicht, dass durch das über der Produktionsfläche 2 angeordnete Schienensystem 40 mittels auf dem Schienensystem 40 angeordneten Transportrobotern TR1,...,TR6 Materialbehälter MB auf die Transportbehälterbereiche 31,...,37 abgesenkt bzw. von den Transportbehälterbereichen 31,...,37 weggehoben werden können. Weiterhin weist die Förderanlage FA einen Materialbereitstellungspunkt 31' auf.

Gemäß FIG 2 weist das Schienensystem 40 einen ersten Satz paralleler Schienen 41 und einen zweiten Satz paralleler Schienen 42 auf, der zweite Satz paralleler Schienen 42 ist senkrecht zu dem ersten Satz paralleler Schienen 41 angeordnet, wobei durch die Anordnung der Schienen 41,42 Öffnungen O vorhanden sind und die Öffnungen O sind deckungsgleich mit dem Planrechtecken A1,...,K21 angeordnet. Dadurch können auf dem Schienensystem 40 fahrende Transportroboter TR1 jede Position des Rasters R als eine Quelle oder als ein Ziel für den Transport oder die Bewegung eines Materialbehälters MB nutzen.

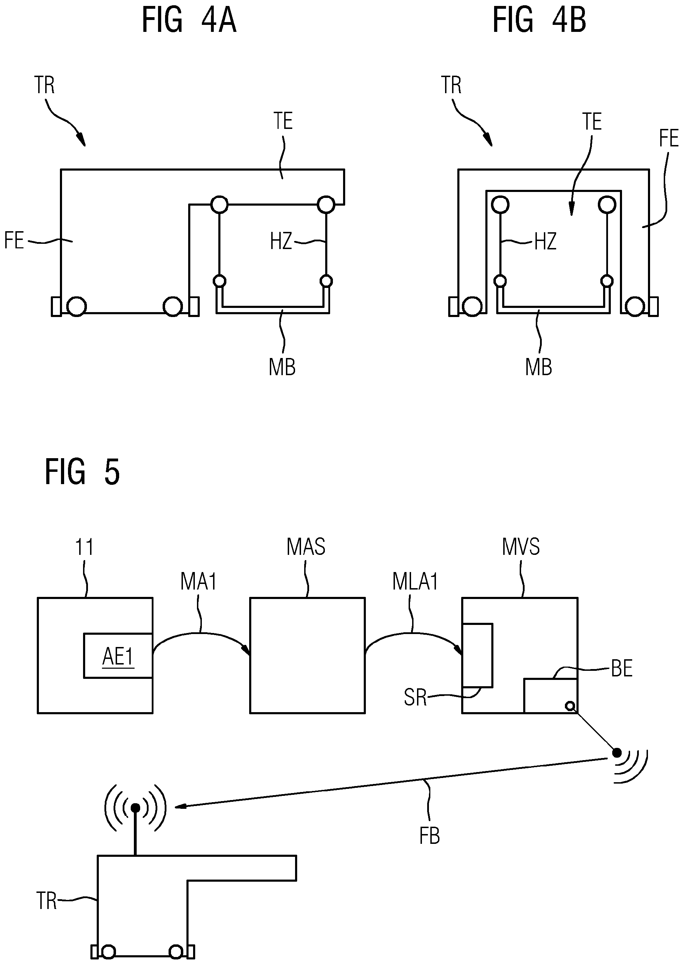

In der FIG 1 sind sechs Transportroboter TR1,...,TR6 dargestellt. Ein erster Transportroboter TR1, ein zweiter Transportroboter TR2, ein dritter Transportroboter TR3, ein vierter Transportroboter TR4 und ein fünfter Transportroboter TR5 stehen für die Versorgung der Produktionsstationen 11,12,13 mit Materialbehältern MB zur Verfügung. Ein sechster Transportroboter TR6 arbeitet mit einem Material-Verteil-System MVS zusammen. Die Transportroboter TR1,...,TR6 weisen eine Fahreinheit FE und eine Transporteinheit TE auf (siehe FIG 4a und 4b). Die Fahreinheit FE ist ausgestaltet, sich parallel zum Schienensystem 40 sowohl in einer X-Richtung als auch in einer Y-Richtung (siehe FIG 2) zu bewegen.

Gemäß FIG 1 holt der erste Transportroboter TR1 von dem ersten Transportbehälterbereich 31 einen Materialbehälter MB ab. Dazu sei angenommen, dass über eine erste Anforderungseinheit AE1 der ersten Produktionsstation 11 eine Anforderung für Material ausgesendet wurde. Dies entspricht der ersten Materialanforderung MA1, welche an ein Materialanforderungssystem MAS geschickt wurde. Das Materialanforderungssystem MAS schickt wiederum einen Materiallieferauftrag MAL1 zu einen Steuerrechner SR, welcher mit dem Material-Verteil-System MVS in Verbindung steht. Das Material-Verteil-System MVS bildet daraus einen Fahrbefehl FB und sendet diesen über eine Funkeinheit bzw. über eine Befehlseinheit BE an den ersten Transportroboter TR1. Nach Erhalt des Fahrbefehls FB wird der erste Transportroboter TR1 sich auf den Schienensystem 40 in Bewegung setzen und genau die Öffnung O in den Planrechteck A1,...,K21 ansteuern durch den er den Materialbehälter auf den zweiten Transportbehälterbereich 32 hinablassen kann. Gemäß FIG 1 und FIG 3 wird der erste Transportroboter TR1 einer ersten Art von Transportrobotern auf den Planrechteck B2 stehen bleiben, so dass er den mit den Hebezeug HZ gehaltenen Materialbehälter MB durch die Öffnung O des durch das Planrechteck B3 gebildeten Öffnung O hinablassen kann. Für den Fall, dass eine zweite Art von Transportroboter eingesetzt wird kann der Materialbehälter durch die Öffnung auf die der Transportroboter steht, nämlich Planrechteck B2, hinabgelassen werden.

Dementsprechend verfügt jede der Produktionsstationen 11,12,13 über je eine Anforderungseinheit AE1,AE2,AE3 zum Absetzen von Materialanforderungen MA1,MA2,MA3.

Für den Einsatz von genormten Transportbehältern als Materialbehälter MB empfiehlt sich eine Rastgröße von 40cm x 60cm. Dementsprechend sollten die Öffnungen O des Schienensystems 40 diese Maße aufweisen.

Unterhalb des Hallenbodens HB befindet sich ein Untergeschoß UG, das Untergeschoß UG wird vorzugsweise als ein Materiallager ML verwendet, wobei das Materiallager ML über eine Förderanlage FA mit dem Material-Verteil-System MVS in Verbindung steht.

Das Materiallager ML weist wiederum Förderbänder auf, auf welchen Materialbehälter MB in einer ersten Richtung 1R in den Versand oder zur Abfallentsorgung geschickt werden.

In einer zweiten Richtung 2R können Materialbehälter MB mit Material oder leere Materialbehälter geholt werden.

Für das Produktionssystem 1 gemäß FIG 1 hat sich folgender Aufbau in einer Halle bewährt, der Hallenboden HB bildet die Produktionsfläche 2, das Untergeschoß UG beherbergt das Materiallager ML und die Förderanlage FA, das Hallendach HD überdeckt die Produktionsfläche 2, wobei zwischen dem Hallendach HD und der Produktionsfläche 2 das Schienensystem 40 über den Produktionsstationen 11,12,13 angeordnet ist.

Mit der FIG 2 wird das Aufspannen des Rasters R über der Produktionsfläche 2 noch einmal verdeutlicht. Im Planrechteck F1 steht ein Transportroboter TR, wobei er das Planrechteck F1 mit seiner Fahreinheit FE überdeckt und das Planrechteck F2 mit seiner Transporteinheit TE überdeckt. Durch die durch das Planrechteck F2 gebildete Öffnung O kann der Transportroboter TR mit seiner Transporteinheit TE über das Hebezeug HZ einen Materialbehälter MB an die geforderte Stelle auf der Produktionsfläche 2 hinablassen, da die Produktionsfläche 2 ebenfalls, wie das Schienensystem 40, in das gleiche Raster R unterteilt wurde.

Gemäß FIG 3 ist schematisch durch das Raster R hindurch die Aufteilung der Produktionsstation 11,12 gezeigt.

Die FIG 4a zeigt den Aufbau eines Transportroboters TR einer ersten Art. Der Transportroboter TR weist also die Fahreinheit FE und die Transporteinheit TE auf, die Fahreinheit FE ist ausgestaltet, sich parallel zum Schienensystem 40 sowohl in einer x-Richtung als auch in einer y-Richtung zu bewegen. Die Transporteinheit TE ist ausgestaltet, mit einem Hebezeug HZ zum Transportieren von Materialbehältern MB, wobei die Fahreinheit FE ein Planrechteck A1,...,K21 abdeckt und das Hebezeug HZ der Transporteinheit TE ausgestaltet ist, den Materialbehälter MB durch die Öffnung O, welche durch das durch die Transporteinheit TE abgedeckte Planrechteck gegeben ist, nun kann der Transportroboter TR den Materialbehälter MB in das vorgesehene Planrechteck absenken bzw. von diesem Planrechteck einen Materialbehälter MB abholen.

Die FIG 4b zeigt den Aufbau eines Transportroboters TR einer zweiten Art. Die Fahreinheit FE und die Transporteinheit TE sind miteinander kombiniert. So kann der Hebezug HZ den Materialbehälter MB direkt durch die Öffnung hinablassen auf der der Transportroboter TR steht. Der Transportroboter TR hat dementsprechend eine Innenaufnahme für den Materialbehälter.

Mit der FIG 5 ist schematisch die Auftragsvergabe dargestellt. Die erste Anforderungseinheit AE1 in der ersten Produktionsstation 11 setzt einen ersten Materialanforderungsauftrag MA1 ab. Der erste Materialanforderungsauftrag MA1 kommt am Materialanforderungssystem MAS an. Dieses generiert daraus einen ersten Materiallieferauftrag MLA1, welcher wiederum an den Steuerrechner SR des Material-Verteil-Systems MVS gesendet wird. Das Material-Verteil-System MVS verfügt über eine Befehlseinheit BE, welche wiederum über Funk einen Fahrbefehl FB an die Transportroboter TR sendet.

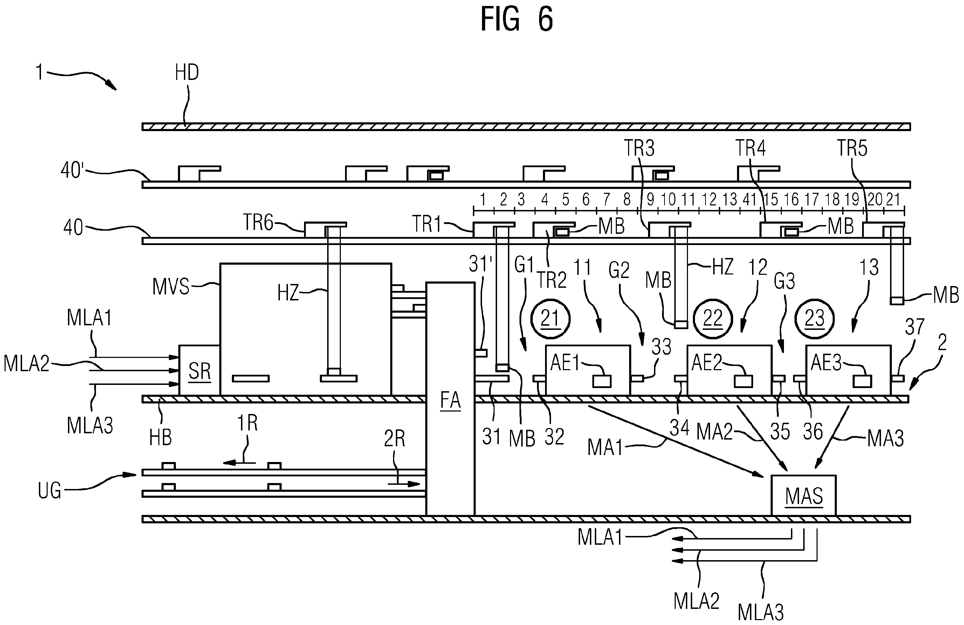

Die FIG 6 zeigt im Wesentlichen das mit FIG 1 dargestellte Produktionssystem 1, wobei FIG 6 die leichte Erweiterbarkeit des Produktionssystems 1 zeigt, wobei zur Erweiterung einfach ein zweites weiteres Schienensystem 40' über das bereits vorhandene Schienensystem 40 angeordnet wird.

Die bauliche Gegebenheit des Untergeschosses ist lediglich eine Ausprägung. Material kann auf jede andere Art und Weise in die Produktion gelangen.

Fertige Produkte in Materialbehälter abgelegt finden ihren Weg zum Versand auf die gleiche Art und Weise. Als wesentlich wird die gute Erreichbarkeit der

Materialversorgungspunkte, an welchen die Transportroboter die Materialbehälter mit Material abholen und Entsorgungspunkte für Produkte in Materialbehälter, leere Materialbehälter und Materialbehälter mit Abfällen. Materialbehälter werden auch an Stichen der Heber angeboten.

Produzierte Produkte werden von den Maschinen der Produktionsstationen oder dessen Personal in leere Materialbehälter geschichtet und auf Transportbehälterbereichen 33, 35, 37 bereitgestellt und bevorzugt durch optionale Sensorik erfasst oder durch manuellen Lieferauftrag zur Abholung durch Transportroboter gemeldet. Der Transportroboter befördert den Materialbehälter zu einem Ziel zur Beförderung zum Versand.

Leere Materialbehälter werden nach Auftrag durch Personal oder durch Sensorik analog an die entsprechenden Positionen der Produktionsstationen geliefert. Materialbehälter mit Abfällen werden nach Auftrag durch Personal oder Sensorik durch Transportroboter abgeholt und nach abliefern an Entsorgungspunkten 31' durch das Fördersystem zum Abfallsortier- und - entsorgungsbereich außerhalb der Produktion transportiert.

## Patentansprüche

1. Produktionssystem (1) umfassend
eine Produktionsfläche (2), welche mit einem Raster (R) in Planrechtecke (A1, ...,K21) aufgeteilt ist,
eine Vielzahl von Produktionsstationen (11,12,13), welche auf der Produktionsfläche (2) angeordnet sind,
eine Vielzahl von Gehwegen (G1,G2,G3), welche zwischen den Produktionsstationen (11,12,13) angeordnet sind,
eine Vielzahl von Arbeitsbereichen (21,22,23), wobei zumindest ein Arbeitsbereich (21,22,23) einer Produktionsstation (11,12,13) zugeordnet ist, wobei die jeweiligen Arbeitsbereiche (21,22,23) mit den Gehwegen (G1,G2,G3) verbunden sind, eine Vielzahl von Transportbehälterbereichen (31,...,37), wobei zumindest eine Produktionsstation (11,12,13) zugeordnet ist, wobei die jeweiligen Transportbehälterbereiche (31,...,37) in einem Planrechteck (A1,...,K21) angeordnet sind,
ein Materialanforderungssystem (MAS) ausgestaltet, das über die Produktionsstationen (11,12,13) ausgesendete Materialanforderungen (MA1,MA2,MA3) in Materiallieferaufträge (MLA) umgesetzt werden und an ein Material-Verteil-System (MVS) gesendet werden,
**dadurch gekennzeichnet, dass** über der Produktionsfläche (2) ein Schienensystem (40) angeordnet ist, wobei das Schienensystem (40) einen ersten Satz paralleler Schienen (41) und einen zweiten Satz paralleler Schienen (42) aufweist, welcher senkrecht zu dem ersten Satz paralleler Schienen (41) angeordnet ist, und durch diese Anordnung der Schienen (41,42), Öffnungen (O) vorhanden sind und die Öffnungen (O) deckungsgleich mit den Planrechtecken (A1,...,K21) angeordnet sind, wobei auf dem Schienensystem (40) Transportroboter (TR1) angeordnet sind, die Transportroboter (TR1) weisen eine Fahreinheit (FE) und eine Transporteinheit (TE) auf, die Fahreinheit (FE) ist ausgestaltet sich parallel zum Schienensystem (40) sowohl in einer x-Richtung als auch in einer y-Richtung zu bewegen, die Transporteinheit (TE) ist ausgestaltet mit einem Hebezeug (HZ) zum Transportieren von Materialbehältern (MB),
wobei die Fahreinheit (FE) ein Planrechteck (A1,...,K21) abdeckt und das Hebezeug (HZ) der Transporteinheit (TE) ausgestaltet ist einen Materialbehälter (MB) durch eine Öffnung (O), auf einen Transportbehälterbereich (31,32,33) abzusenken bzw. von dem Transportbehälterbereich (31,32,33) zu heben.

2. Produktionssystem (1) nach Anspruch 1, wobei ein weiteres Schienensystem (40`) über dem bereits vorhandenen Schienensystem (40) angeordnet ist.

3. Produktionssystem (1) nach Anspruch 1 oder 2, wobei die Produktionsstationen (11,12,13) eine Anforderungseinheit (AE1,AE2,AE3) zum Absetzen von Materialanforderungen (MA1,MA2,MA3) aufweisen.

4. Produktionssystem (1) nach einem der Ansprüche 1 bis 3, wobei die Öffnungen (O) des Schienensystems (40) mindestens die Maße von 40cm x 60cm aufweisen.

5. Produktionssystem (1) nach einem der Ansprüche 1 bis 4, aufweisend ein Materiallager (ML), welches über eine Förderanlage (FA) mit dem Material-Verteilsystem (MVS) in Verbindung steht.

6. Produktionssystem (1) nach Anspruch 5, mit folgendem Aufbau in einer Halle
ein Hallenboden (HB) bildet die Produktionsfläche (2),
ein Untergeschoß (UG) beherbergt das Materiallager und die Förderanlage (FA),
ein Hallendach (HD) überdeckt die Produktionsfläche (2), wobei zwischen dem Hallendach (HD) und der Produktionsfläche (2) das Schienensystem (40) über den Produktionsstationen (11,12,13) angeordnet ist.

7. Produktionssystem (1) nach einem der Ansprüche 1 bis 6, wobei die Transporteinheit (TE) und das Hebezeug (HZ) ausgestaltet ist die Materialbehälter (MB) den Transportbehälterbereichen (31,...,37) zu überlassen oder von diesen abzuholen.

8. Produktionssystem (1) nach einem der Ansprüche 1 bis 7, wobei eine Festlegung der Ziel- und Quellepositionen der Planrechtecke (A1,...,K21) zum Absenken oder Anheben der Materialbehälter (MB) ist über ein Softwareleitsystem jederzeit frei wählbar ist.
